# FASCICULE DE BREVET EUROPEEN

(11) **EP 1 499 013 B1**
(45) Date de publication et mention de la délivrance du brevet: **23.04.2008**
(21) Numéro de dépôt: 04291660.1
(22) Date de dépôt: 30.06.2004
(51) Int. Cl.: H03F 3/21, H04B 1/04

(54) **Dispositif d'amplification pour satellite**
Satelliten-Verstärkervorrichtung
Amplifier device for satellite

(30) Priorité: 11.07.2003 FR 0308522
(43) Date de publication de la demande: 19.01.2005
(73) Titulaire: Alcatel Lucent, 75008 Paris (FR)
(72) Inventeur: Hoffmann, Matthieu, 31130 Flourens (FR); Voisin, Philippe, 31100 Toulouse (FR)
(74) Mandataire: Esselin, Sophie

(56) Documents cités:
- DE-A- 19 549 356
- US-A- 5 289 193
- US-A- 5 638 024
- US-A- 5 917 371
- US-A- 5 955 920

## Description

La présente invention concerne un dispositif d'amplification pour satellite adapté pour répartir flexiblement une pluralité de canaux de transmission reçus vers une pluralité de faisceaux de sortie.

Dans le cas général des missions spatiales, l'évolution des transmissions satellites vers des utilisateurs équipés de terminaux d'émission/réception à capacité réduite et de petite dimension implique une augmentation de la qualité de réception du segment embarqué ainsi qu'une augmentation de la puissance des signaux retransmis au sol. Ces augmentations de performance sont obtenues par l'accroissement des gains antenne à bord, ce qui ne peut être obtenu qu'en réduisant les dimensions de leurs couvertures au sol. Ces réductions de couverture nécessitent, pour couvrir une zone géographique de couverture particulière au sol, de générer plusieurs faisceaux ou spots afin d'échantillonner la zone géographique. De telles couvertures multifaisceaux ou multispots rendent possibles des liaisons avec des petits terminaux sol mais elles posent le problème de la gestion des capacités bord et plus particulièrement de l'allocation des canaux reçus vers les faisceaux transmis en fonction :
- des densités différentes de trafic,
- d'évolutions dans le temps des densités de trafic.

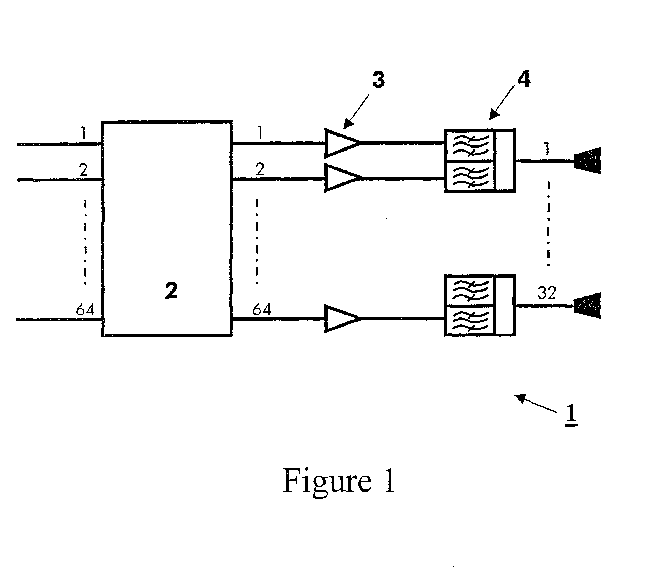

Ainsi, de manière connue et comme représenté schématiquement sur l'architecture 1 de la figure 1, un satellite reçoit 64 signaux correspondant chacun à un canal de transmission et fournit 32 faisceaux. Les 64 canaux sont traités par une section d'entrée 2 qui effectue :
- une réception faible bruit, une conversion de fréquence adéquate et un filtrage adapté pour chacun des 64 canaux de transmission,
- une restitution de chacun des 64 canaux vers un amplificateur 3.

Un canal de transmission correspond à une bande de fréquence de transmission et peut correspondre à une porteuse unique ou un ensemble de porteuses ou sous-canaux.

Chaque canal de transmission est amplifié par l'amplificateur 3 qui lui est associé. Les amplificateurs 3 sont des amplificateurs haute puissance et sont généralement réalisés par des tubes à ondes progressives ou des amplificateurs à état solide. Afin de disposer de plusieurs canaux par faisceau, il faut combiner les canaux au travers de multiplexeurs de sortie 4. Le multiplexeur de sortie 4 ou OMUX (Output MUltipleXer), prévu en sortie de chaque amplificateur, est tel que décrit dans l'ouvrage « Satellite communications systems » (G. Maral et M. Bousquet, Edition WILEY, seconde édition, page 411 et suivantes). Ce multiplexeur 4 comprend des filtres et un guide commun qui est destiné à combiner les canaux de transmission après leur amplification. Dans le cas de la figure 1, chaque multiplexeur de sortie 4 peut recevoir deux canaux de transmission et fournit un signal de faisceau. Chaque signal de faisceau est ensuite envoyé sur une source non représentée tel qu'un cornet qui rayonne vers un réflecteur non représenté pour la formation du faisceau. Ainsi, une telle architecture permet d'avoir deux canaux de transmission par faisceau à la descente.

Toutefois, les opérateurs n'ont pas toujours une visibilité très nette sur la répartition future du trafic (et donc de la puissance) sur les couvertures adressées et ont donc besoin de disposer d'une certaine flexibilité permettant de s'adapter pendant la durée de vie du satellite aux besoins en trafic résultant de la demande et du succès de services sur différentes zones géographiques. Il est donc important de pouvoir router les canaux de transmission de manière flexible vers les faisceaux, c'est à dire de telle manière que le nombre total de canaux traités par la charge utile puisse être réparti vers les différents faisceaux conformément à la demande de trafic et ce durant la durée de vie du satellite. En ce sens, l'architecture telle que représentée en figure 1 ne permet aucune flexibilité en terme de nombre de canaux alloués par faisceau et requiert un nombre d'amplificateurs qui est imposé par le nombre de canaux à amplifier.

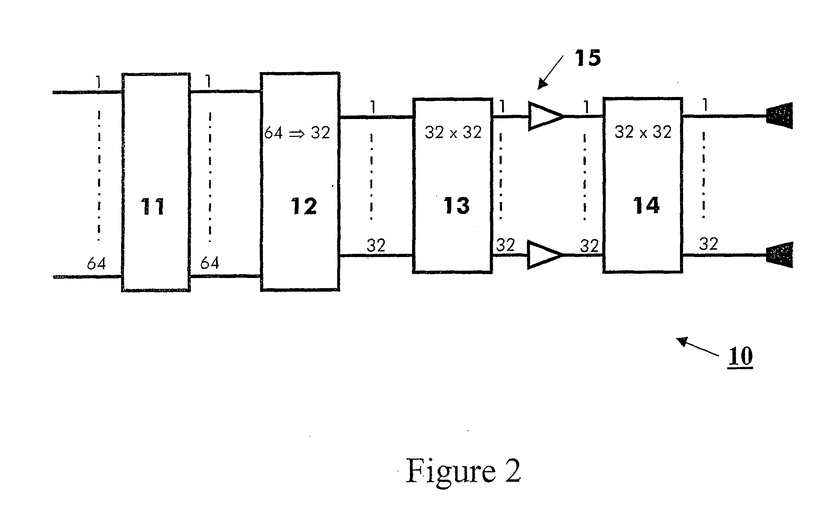

Une solution connue à ce problème consiste à utiliser un dispositif 10 du type MPA (MultiPort Amplifier) tel que représenté en figure 2 et qui permet d'assurer de façon flexible l'amplification et l'allocation de 64 canaux de transmission sur 32 faisceaux. Le dispositif 10 comporte :
- une section 11 d'entrée à 64 entrées et 64 sorties, qui effectue, comme pour la section 2, une réception faible bruit, une conversion de fréquence adéquate et un filtrage adapté pour chacun des 64 canaux de transmission,
- un commutateur 12 à 64 entrées et 32 sorties,
- une matrice 13 de type Butler à 32 entrées et 32 sorties,
- une matrice 14 de type Butler inverse à 32 entrées et 32 sorties,
- 32 amplificateurs haute puissance 15, chaque sortie de la matrice 13 étant reliée à l'entrée correspondante de la matrice 14 via un amplificateur haute puissance 15.

On entend par matrice 14 de type Butler inverse une matrice ayant une fonction de transfert inverse de la matrice de Butler 13,

Ainsi, la section d'entrée 11 reçoit 64 canaux de transmission montants et effectue :
- une réception faible bruit, une conversion de fréquence adéquate et un filtrage adapté de chacun des 64 canaux de transmission,
- une restitution des 64 canaux de transmission sur les 64 entrées du commutateur 12.

Le commutateur 12 est un commutateur bas niveau (c'est à dire à faible puissance), généralement électromécanique ou électronique, qui se contente de router les canaux présents sur ses 64 entrées vers ses 32 sorties et de les multiplexer (sommation de plusieurs canaux sur une même sortie). La complexité du commutateur 12 dépend du degré de flexibilité requis se traduisant par le nombre de sorties vers lesquelles peut être routé chaque canal et le nombre de canaux qui peuvent être routés vers une même sortie.

Les signaux de sortie du commutateur 12 qui peuvent correspondre à plusieurs canaux sont alors envoyés sur les 32 entrées de la matrice de Butler 13.

Dans la matrice 13 de type Butler, qui est formée de coupleurs 3 dB, le signal sur chaque sortie est une combinaison des signaux sur toutes les entrées, mais les signaux provenant des diverses entrées ont une phase prédéterminée, distincte d'une entrée à une autre, ce qui permet après amplification par les amplificateurs 15 et passage dans la matrice 14 de type Butler inverse, de reconstituer intégralement les signaux d'entrée. En d'autres termes, on retrouve à l'identique les 32 signaux de sortie du commutateur, après amplification, sur les ports de sortie de la matrice 14 de type Butler inverse (produit identité de la matrice 13 de type Butler par la matrice 14 de type Butler inverse). Chaque amplificateur 15 participe à l'amplification de tous les signaux présents sur les entrées de la matrice de Butler 13. Une fois dimensionné pour passer un nombre maximum de canaux de transmission, un tel dispositif 10 autorise n'importe quelle distribution.

Chaque signal de faisceau obtenu sur les sorties de la matrice de type Butler inverse 14 est ensuite envoyé sur une source non représentée tel qu'un cornet qui rayonne vers un réflecteur non représenté pour la formation du faisceau.

Ainsi, le dispositif 10 permet une flexibilité totale dans la mesure où il serait possible fonctionnellement d'allouer chacun des 64 canaux de transmission à chacun des 32 faisceaux. Il est ainsi fonctionnellement possible de mettre tous les canaux de transmission amplifiés sur un seul faisceau ou de les distribuer également entre les faisceaux, l'allocation des faisceaux étant réalisée en amont des matrices de Butler par le commutateur 12.

Toutefois, la mise en oeuvre d'une telle solution pose certaines difficultés, en particulier le problème de faisabilité d'un dispositif MPA d'ordre élevé lié à la faisabilité des matrices de Butler et la mise en parallèle d'un nombre élevé d'amplificateurs de puissance ainsi qu'une perte d'efficacité en terme de rendement énergétique du dispositif 10 de la figure 2 comparativement au dispositif 1 de la figure 1.

Ainsi, il est courant de trouver (application multimédia en bande Ka) jusqu'à 64 faisceaux et plus pour assurer la couverture d'un continent. Dès lors, des dispositifs MPA à 64 entrées et 64 sorties ou même à 64 entrées et 32 sorties tels que représenté en figure 2, sont extrêmement difficiles à réaliser, notamment de par la complexité des matrices de Butler utilisées.

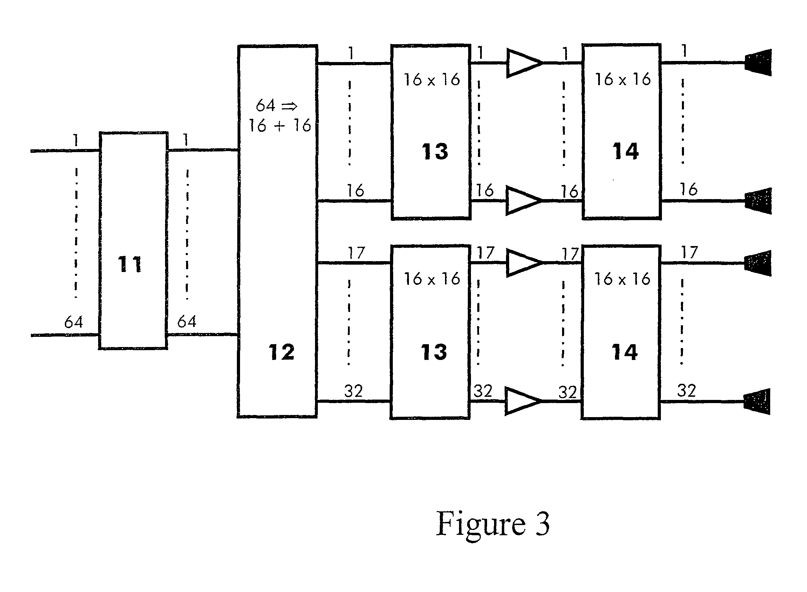

Une possibilité consiste à fractionner les matrices de Butler 13 et 14 en utilisant plusieurs sous-groupes de matrices de Butler de plus petite taille. Par exemple, la figure 3 représente un tel dispositif identique au dispositif 10 de la figure 2 à la différence que les matrices 13 et 14 de la figure 2 ont été fractionnées en 2 sous-matrices identiques à 16 entrées et 16 sorties. Cependant une telle solution est moins flexible dans la mesure où, pour éviter un surdimensionnement des amplificateurs de puissance, il n'est pas possible d'amplifier les 64 canaux de transmission dans une même sous-matrice. Pour utiliser les mêmes amplificateurs que ceux du dispositif 10 de la figure 2, il faut que le nombre de canaux traités par sous-matrice n'excède pas 32 et donc que le dispositif 12 répartisse les 64 canaux en 2 blocs de 32 canaux. Cette contrainte limite donc la flexibilité du dispositif de la figure 3 par rapport à celle du dispositif 10 de la figure 2.

En outre, il est à noter que, dans une solution du type MPA, il faut que le nombre d'entrées et de sorties des matrices de type Butler et Butler inverse soit au moins égal au nombre de faisceaux pour permettre de connecter tous les accès faisceaux à la sortie du dispositif MPA. Ainsi, le nombre d'amplificateurs requis est imposé par le nombre de faisceaux, ce qui se traduit par un coût élevé et un aménagement complexe.

Enfin, lorsque tous les canaux sont transmis via un dispositif MPA, chaque amplificateur de puissance contribue à l'amplification d'un nombre élevé de canaux (64 canaux par amplificateur pour le dispositif 10 de la figure 2) comparativement au dispositif 1 de la figure 1 (1 canal par amplificateur pour le dispositif 1). Ce fonctionnement multicanaux se traduit par une obligation de fonctionnement de l'amplificateur de puissance loin de son point de saturation ce qui se traduit par une perte de son rendement énergétique (puissance délivrée/puissance consommée) et donc, à puissance délivrée par canal de transmission identique pour les dispositifs 1 et 10, par une augmentation conséquente de la puissance consommée pour le dispositif 10. Le gain en flexibilité du dispositif 10 comparativement au dispositif 1 se traduit donc par une dégradation du bilan énergétique.

Le document US 5.955.920 (Rendink et al.) décrit une exemple d'un dispositif pour amplifier et répartir flexiblement une pluralité de canaux de transmission selon l'état de la technique.

La présente invention vise à fournir un dispositif pour satellite adapté pour amplifier et répartir flexiblement une pluralité P de canaux de transmission d'entrée vers N sorties correspondant chacune à un faisceau, avec un nombre réduit d'amplificateurs de puissance tout en conservant une bonne flexibilité.

La présente invention propose à cet effet un dispositif pour satellite adapté pour amplifier et répartir flexiblement une pluralité P de canaux de transmission d'entrée vers N sorties correspondant chacune à un faisceau, ledit dispositif comportant :
- un commutateur comprenant P entrées pour le routage de ladite pluralité P de canaux de transmission vers une pluralité de sorties,
- au moins une matrice de type Butler dont chaque entrée est connectée à une sortie dudit commutateur,
- au moins une matrice de type Butler inverse, chaque sortie de ladite matrice de type Butler étant reliée à une entrée correspondante de ladite matrice de type Butler inverse par l'intermédiaire d'un amplificateur,
ledit dispositif étant **caractérisé en ce qu'il** comporte une pluralité de démultiplexeurs de sortie pour séparer fréquentiellement une pluralité de canaux de transmission, l'entrée de chacun desdits démultiplexeurs de sortie étant reliée à une sortie de ladite matrice de type Butler inverse.

Grâce à l'invention, le couplage avantageux entre une technologie de type MPA (MultiPort Amplifier) et l'utilisation de démultiplexeurs de sortie ou ODEMUX (Output DEMUltipleXer) permet d'allouer les canaux de transmission à un nombre de faisceaux plus élevé que le nombre d'entrées de la matrice de type Butler (N > P). Ainsi, en prenant un ODEMUX (qui comporte au moins deux sorties) sur chaque sortie de la matrice de type Butler inverse, on a nécessairement un nombre d'entrées de la matrice de type Butler inférieur ou égal à la moitié du nombre de faisceaux. L'ODEMUX permet de séparer fréquentiellement sur le même port de sortie de la matrice de type Butler inverse des signaux de fréquences différentes qui seront utilisés pour des faisceaux différents. Ainsi, un port de sortie peut adresser deux faisceaux si l'ODEMUX comporte deux sorties.

En outre, pour aboutir à une solution équivalente à celle obtenue avec une technologie MPA ou MPA fractionnée, le dispositif selon l'invention nécessite au moins deux fois moins d'amplificateurs (cas d'un ODEMUX à deux sorties), en supposant que la puissance demandée à chaque amplificateur, au moins deux fois plus importante que celle demandée avec une technologie MPA ou MPA fractionnée, soit effectivement délivrable par un seul amplificateur. Si ce n'était pas le cas, le nombre d'amplificateurs du dispositif selon l'invention serait au plus égal à celui obtenu avec une technologie MPA ou MPA fractionnée.

De plus, le niveau de flexibilité est accru par rapport à une solution du type MPA fractionnée. Ainsi, pour assurer une même flexibilité (par exemple sur 32 faisceaux), la solution du type MPA fractionné nécessite deux sous-groupes comportant chacun une matrice de type Butler à 16 entrées et 16 sorties et une matrice de type Butler inverse à 16 entrées et 16 sorties. La flexibilité est uniquement assurée à l'intérieur de chacun des deux sous-groupes, donc vers seulement huit faisceaux au sein d'un même sous-groupe. Le dispositif selon l'invention permet d'adresser les 32 faisceaux avec une seule matrice de type Butler à 16 entrées et 16 sorties et une seule matrice de type Butler inverse à 16 entrées et 16 sorties, la flexibilité étant réalisée vers les 32 faisceaux.

La présente invention permet ainsi d'utiliser des MPA d'ordre raisonnable mais restant compatible avec la génération d'un nombre de faisceaux important.

Selon un mode de réalisation, ledit dispositif comporte :
- un commutateur à P entrées et Q sorties pour le routage desdits P canaux de transmission vers lesdites Q sorties,
- k1 matrices de type Butler ayant chacune Q/k1 entrées et Q/k1 sorties, où k1 est un entier naturel non nul et Q est un multiple entier de k1,
- k1 matrices de type Butler inverse ayant chacune Q/k1 entrées et Q/k1 sorties, chaque sortie de chacune des k1 matrices de type Butler étant reliée à une entrée correspondante d'une des k1 matrices de type Butler inverse par l'intermédiaire d'un amplificateur,
- Q démultiplexeurs de sortie comportant chacun une entrée et k2 sorties, chacune desdites Q/k1 sorties associées à chaque matrice de type Butler inverse étant relié à l'entrée d'un desdits Q démultiplexeurs, k2 étant un entier naturel non nul tel que N soit égal à Q.k2.

La présente invention a également pour objet un système d'amplification pour satellite adapté pour répartir flexiblement un nombre P de canaux de transmission d'entrée, ledit système comportant un nombre P' d'entrées pour recevoir P' canaux de transmission d'entrée, ledit nombre P' d'entrée étant supérieur au dit nombre P de canaux de transmission d'entrée à répartir flexiblement, ledit système étant caractérisé en ce qu'il comporte :
- un dispositif selon l'invention adapté pour amplifier et répartir flexiblement P canaux de transmission d'entrée,
- une pluralité d'amplificateurs pour l'amplification des P' ― P canaux de transmission restants.

Ainsi, cette architecture de système s'intercale entre une solution non flexible et une solution flexible utilisant le dispositif selon l'invention. Elle présente un rendement énergétique acceptable et une bonne flexibilité sur une quantité P non négligeable de canaux. Une telle solution permet de trouver un bon compromis entre la flexibilité requise et le rendement global.

Cette architecture offre la possibilité d'associer ce dispositif à un schéma d'amplification classique (tel que décrit en figure 1) permettant d'offrir une flexibilité sur tous les faisceaux tout en gérant le bilan énergétique total.

Avantageusement, le système d'amplification comporte une pluralité de multiplexeurs de sortie, chacun desdits multiplexeurs de sortie ayant une entrée reliée directement à une sortie d'un desdits amplificateurs pour l'amplification desdits P' ― P canaux de transmission restant et une autre entrée reliée au dispositif selon l'invention qui gère flexiblement les P canaux de transmission.

D'autres caractéristiques et avantages de la présente invention apparaîtront dans la description suivante de modes de réalisation de l'invention, donnés à titre illustratif et nullement limitatif.

Dans les figures suivantes :
- La figure 1 représente schématiquement une architecture d'amplification selon l'état de la technique,
- La figure 2 représente schématiquement un premier mode de réalisation de dispositif d'amplification et d'allocation flexible selon l'état de la technique,
- La figure 3 représente schématiquement un deuxième mode de réalisation de dispositif d'amplification et d'allocation flexible selon l'état de la technique,
- La figure 4 représente schématiquement un dispositif pour satellite selon l'invention,
- La figure 5 représente schématiquement un système d'amplification selon l'invention.

Les figures 1, 2 et 3 ont déjà été décrites en relation avec l'état de la technique.

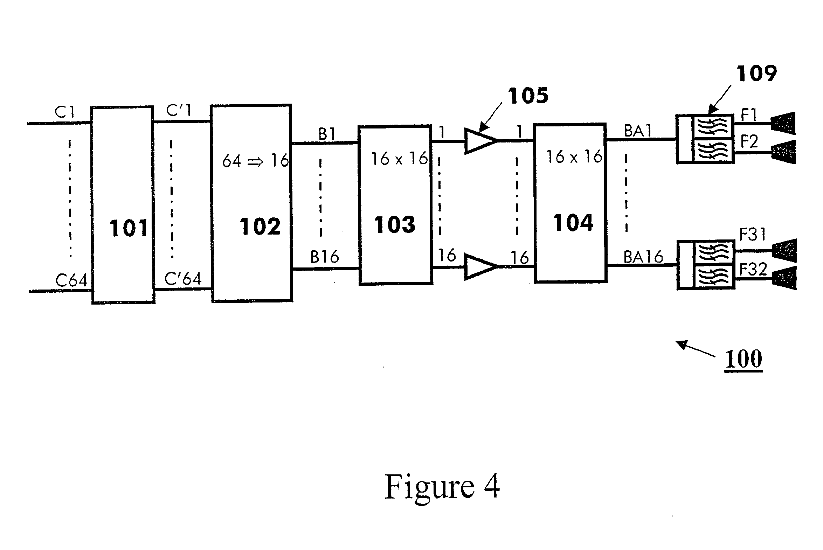

La figure 4 représente un dispositif 100 adapté pour amplifier et répartir flexiblement P (P=64) signaux C1 à C64 de canal d'entrée vers N (N=32) signaux de sorties F1 à F32 correspondant chacun à un faisceau.

Le dispositif 100 comporte :
- une section 101 d'entrée à 64 entrées et 64 sorties,
- un commutateur 102 à P (P=64) entrées et Q (Q=16) sorties,
- k1 (k1=1) matrice 103 de type Butler à Q/k1 (Q/k1 = 16) entrées et Q/k1 (Q/k1 = 16) sorties,
- k1 (k1=1 ) matrice 104 de type Butler inverse à Q/k1 (Q/k1 = 16) entrées et Q/k1 (Q/k1 = 16) sorties,
- Q (Q=16) amplificateurs de puissance 105,
- Q (Q=16) démultiplexeurs de sortie 109 ou ODEMUX (Output DEMUltipleXer) ayant une entrée et k2 (k2=2) sorties.

Chacun des ODEMUX 109 est un dispositif permettant de séparer fréquentiellement sur ses sorties plusieurs canaux présents en entrée. Structurellement, un ODEMUX est multiplexeur OMUX inversé tel que décrit dans l'ouvrage « Satellite communications systems » (G. Maral et M. Bousquet, Edition WILEY, seconde édition, page 411 et suivantes).

Chacun des amplificateurs de puissance 105 est généralement un tube amplificateur à ondes progressives mais il peut également s'agir d'un amplificateur à semiconducteur SSPA (Solid State Power Amplifier).

Chaque sortie de la matrice 103 est reliée à l'entrée correspondante de la matrice 104 via un des amplificateurs de puissance 105.

On entend par matrice 104 de type Butler inverse une matrice ayant une fonction de transfert inverse de la matrice de Butler 103.

Ainsi, la section d'entrée 101 reçoit les 64 canaux de transmission montants C1 à C64 correspondant chacun à un canal de transmission. La section d'entrée 101 effectue alors les opérations suivantes :
- conversion de fréquence adéquate de chacun des 64 canaux de transmission C1 à C64 et filtrage,
- restitution de 64 canaux de transmission C'1 à C'64 sur les 64 entrées du commutateur 102.

Le commutateur 102 est un commutateur bas niveau (c'est à dire fonctionnant à très faible puissance), généralement électromécanique ou électronique, qui se contente de router les signaux présents sur ses entrées vers l'une de ses 16 sorties et de les combiner.

Les signaux de sorties B1 à B16 du commutateur 102 qui peuvent correspondre à plusieurs signaux de canaux sont alors envoyés sur les 16 entrées de la matrice de Butler 103.

Dans la matrice 103 de type Butler, qui est formée de coupleurs 3 dB, le signal sur chaque sortie est une combinaison des signaux sur toutes les entrées, mais les signaux provenant des diverses entrées ont une phase prédéterminée, distincte d'une entrée à une autre, ce qui permet après amplification par les amplificateurs 105 et passage dans la matrice 104 de type Butler inverse, de reconstituer intégralement les signaux d'entrées.

Ainsi, on retrouve à l'identique les 16 signaux B1 à B16 de sortie du commutateur 101, après amplification, sur les ports de sortie de la matrice 104 de type Butler inverse puisque le produit de la matrice 103 de type Butler par la matrice 104 de type Butler inverse est égal à l'identité.

Chaque amplificateur 105 participe à l'amplification de tous les signaux présents B1 à B16 sur les entrées de la matrice de Butler 103. Bien entendu, les amplificateurs 105 sont dimensionnés pour passer un nombre maximum prédéterminé de canaux.

Notons BA1 à BA16 les signaux amplifiés obtenus sur les ports de sortie de la matrice 104 de type Butler inverse.

Chaque signal BA1 à BA16 arrive sur une entrée d'un ODEMUX 109 correspondant et est séparé fréquentiellement par cet ODEMUX. Les 16 ODEMUX 109 fournissent alors 32 signaux F1 à F32 correspondant chacun à un faisceau.

Chaque signal F1 à F32 obtenu sur les sorties du dispositif 100 est ensuite envoyé sur une source non représentée tel qu'un cornet qui rayonne vers un réflecteur non représenté pour la formation du faisceau.

Chaque signal BA1 à BA16 peut comprendre une pluralité de canaux de transmission. Bien entendu, les canaux de transmission présents sur les entrées des ODEMUX doivent présenter un espacement fréquentiel suffisant pour être démultiplexés. Mais cette contrainte est pratiquement résolue implicitement dans la mesure où, dans un système multifaisceaux, les contraintes système imposent également une séparation fréquentielle des canaux entre faisceaux adjacents. Dès lors, deux faisceaux adjacents correspondant par exemple à deux sorties d'un ODEMUX 109 devant comporter des signaux de canaux bien séparés, la séparation des canaux pour autoriser le démultiplexage est également vérifiée.

Dans le dispositif 100 selon l'invention, on a utilisé 16 amplificateurs, soit deux fois moins que dans le cas du dispositif 10 de l'état de la technique tel que représenté en figure 2.

Notons ici qu'on peut également utiliser un commutateur à 64 entrées et 8 sorties, une seule matrice de Butler et une seule matrice de Butler inverse ayant chacune 8 entrées et 8 sorties et des ODEMUX à quatre sorties de démultiplexage. On a dans ce cas 8 amplificateurs, soit un gain d'un facteur 4 par rapport au dispositif 10 de la figure 2.

Notons en outre qu'on peut utiliser un nombre k1 plus élevé de matrices de Butler et Butler inverse (par exemple k1=2 matrices de Butler 16×16 et deux matrices de Butler inverse 16x16).

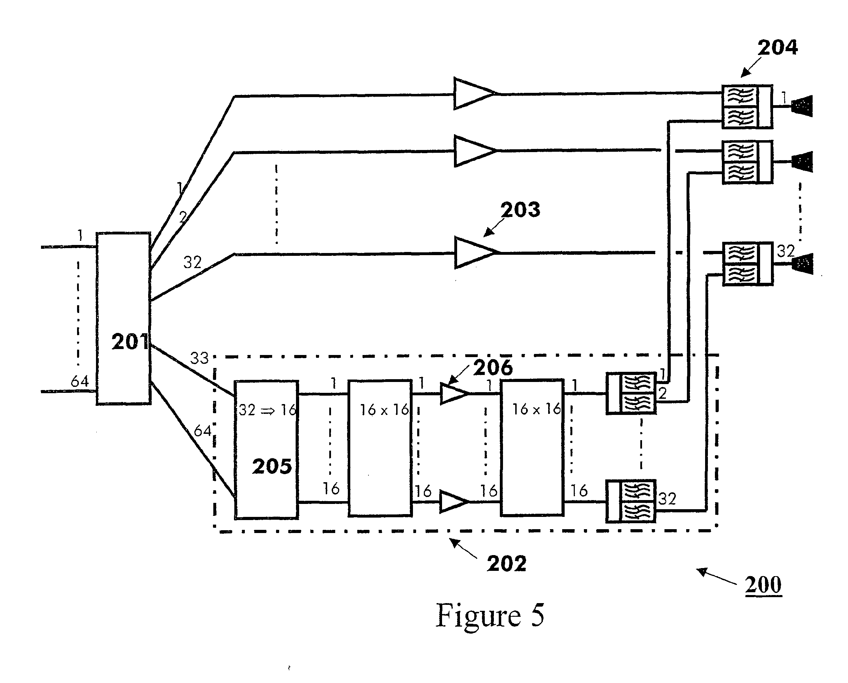

La figure 5 représente schématiquement un système d'amplification 200 selon l'invention.

Le système d'amplification 200 comporte:
- une section d'entrée 201 ayant 64 entrées et 64 sorties,
- 32 amplificateurs 203,
- un module 202 ayant 32 entrées et 32 sorties,
- 32 multiplexeurs de sortie 204.

La section d'entrée 201 reçoit 64 canaux de transmission montants. La section d'entrée 201 effectue alors les opérations suivantes :
- conversion de fréquence adéquate de chacun des 64 canaux de transmission et filtrage,
- restitution de 2 blocs de 32 canaux,

Les 32 premiers canaux de transmission en sortie de la section d'entrée 201 sont chacun injectés directement sur l'entrée d'un des 32 amplificateurs 203.

Les 32 autres canaux de transmission sont injectés en entrée du module 202.

Le module 202 a par exemple une structure identique à celle du dispositif 100 représenté en figure 4 à la différence qu'il ne comporte pas de section d'entrée et que son commutateur 205 comporte 32 entrées (au lieu des 64 entrées du dispositif 100).

Le module 202 permet d'amplifier et de répartir flexiblement ses 32 canaux de transmission d'entrée vers ses 32 sorties.

Chaque signal de sortie du module 202 peut ensuite être multiplexé avec un signal de sortie d'un amplificateur 203 via un multiplexeur de sortie 204.

Les 32 multiplexeurs de sorties 204 fournissent ainsi 32 signaux de sortie correspondant chacun à un faisceau.

Le module 202 comporte 16 amplificateurs 206.

Ainsi, le système 200 permet, avec 48 amplificateurs, une très bonne flexibilité de répartition de 32 canaux de transmission (soit 1/2 des canaux de transmission) sur 32 faisceaux tout en conservant un rendement global élevé dans la mesure ou seule une partie des canaux est gérée de façon flexible.

A titre de comparaison, le rendement énergétique d'un tel système se situe entre le rendement d'un système équivalant non flexible tel que celui représenté en figure 1 et un système totalement flexible tel que celui représenté en figure 2.

Bien entendu, l'invention n'est pas limitée au mode de réalisation qui vient d'être décrit.

Notamment, l'invention a été décrite avec des ODEMUX à deux sorties mais on peut également utiliser des ODEMUX ayant plus de deux sorties (quatre par exemple).

De même, les commutateurs utilisés ont été décrits comme étant des commutateurs électromécaniques mais il peut également s'agir de commutateurs électroniques.

## Revendications

1. Dispositif (100) pour satellite adapté pour amplifier et répartir flexiblement une pluralité P de canaux de transmission d'entrée vers N sorties correspondant chacune à un faisceau, ledit dispositif comportant :
- un commutateur (102) comprenant au moins P entrées pour le routage de ladite pluralité P de canaux de transmission vers une pluralité de sorties,
- au moins une matrice (103) de type Butler dont chaque entrée est connectée à une sortie dudit commutateur,
- au moins une matrice (104) de type Butler inverse, chaque sortie de ladite matrice de type Butler étant reliée à une entrée correspondante de ladite matrice de type Butler inverse par l'intermédiaire d'un amplificateur (105),
ledit dispositif (100) étant **caractérisé en ce qu**'il comporte une pluralité de démultiplexeurs (109) de sortie pour séparer fréquentiellement une pluralité de canaux de transmission, l'entrée de chacun desdits démultiplexeurs de sortie étant reliée à une sortie de ladite matrice de type Butler inverse.

2. Dispositif selon la revendication 1 **caractérisé en ce que** ledit dispositif comporte :
- un commutateur (102) à P entrées et Q sorties pour le routage desdits P canaux de transmission vers lesdites Q sorties,
- k1 matrices de type Butler (103) ayant chacune Q/k1 entrées et Q/k1 sorties, où k1 est un entier naturel non nul et Q est un multiple entier de k1,
- k1 matrices de type Butler inverse (104) ayant chacune Q/k1 entrées et Q/k1 sorties, chaque sortie de chacune des k1 matrices de type Butler étant reliée à une entrée correspondante d'une des k1 matrices de type Butler inverse par l'intermédiaire d'un amplificateur,
- Q démultiplexeurs (109) de sortie comportant chacun une entrée et k2 sorties, chacune desdites Q/k1 sorties associées à chaque matrice de type Butler inverse étant relié à l'entrée d'un desdits Q démultiplexeurs, k2 étant un entier naturel non nul tel que N soit égal à Q.k2.

3. Système (200) d'amplification pour satellite adapté pour répartir flexiblement un nombre P de canaux de transmission d'entrée, ledit système comportant un nombre P' d'entrées pour recevoir P' canaux de transmission d'entrée, ledit nombre P' d'entrée étant supérieur au dit nombre P de canaux de transmission d'entrée à répartir flexiblement, ledit système étant **caractérisé en ce qu'**il comporte :
- un dispositif (202) selon l'une des revendications 1 ou 2 adapté pour amplifier et répartir flexiblement P canaux de transmission d'entrée,
- une pluralité d'amplificateurs (203) pour l'amplification des P' - P canaux de transmission restants.

4. Système (200) d'amplification selon la revendication 3 **caractérisé en ce qu**'il comporte une pluralité de multiplexeurs (204) de sortie, chacun desdits multiplexeurs de sortie ayant une entrée reliée à une sortie d'un desdits amplificateurs pour l'amplification desdits P' - P canaux de transmission restants et une autre entrée reliée au dispositif selon l'une des revendications 1 ou 2.

## Claims

1. Device (100) for satellite adapted for amplifying and flexibly distributing a plurality P of input transmission channels to N outputs each corresponding to a beam, said device comprising:
- a switch (102) comprising at least P inputs for routing said plurality P of transmission channels to a plurality of outputs,
- at least one matrix (103) of Butler type, each input of which is connected to an output of said switch,
- at least one matrix (104) of inverse Butler type, each output of said matrix of Butler type being linked to a corresponding input of said matrix of inverse Butler type by way of an amplifier (105), said device (100) being **characterized in that** it comprises a plurality of output demultiplexers (109) for frequentially separating a plurality of transmission channels, the input of each of said output demultiplexers being linked to an output of said matrix of inverse Butler type.

2. Device according to Claim 1, **characterized in that** said device comprises:
- a switch (102) with P inputs and Q outputs for routing said P transmission channels to said Q outputs,
- k1 matrices of Butler type (103) each having Q/k1 inputs and Q/k1 outputs, where k1 is a nonzero natural integer and Q is an integer multiple of k1,
- k1 matrices of inverse Butler type (104) each having Q/k1 inputs and Q/k1 outputs, each output of each of the k1 matrices of Butler type being linked to a corresponding input of one of the k1 matrices of inverse Butler type by way of an amplifier,
- Q output demultiplexers (109) each comprising an input and k2 outputs, each of said Q/k1 outputs associated with each matrix of inverse Butler type being linked to the input of one of said Q demultiplexers, k2 being a nonzero natural integer such that N is equal to Q.k2.

3. Amplifying system (200) for satellite adapted for flexibly distributing a number P of input transmission channels, said system comprising a number P' of inputs for receiving P' input transmission channels, said input number P' being greater than said number P of input transmission channels to be flexibly distributed, said system being **characterized in that** it comprises:
- a device (202) according to one of Claims 1 or 2, adapted for amplifying and flexibly distributing P input transmission channels,
- a plurality of amplifiers (203) for amplifying the P' - P remaining transmission channels.

4. Amplifying system (200) according to Claim 3, **characterized in that** it comprises a plurality of output multiplexers (204), each of said output multiplexers having an input linked to an output of one of said amplifiers for amplifying said P' - P remaining transmission channels and another input linked to the device according to one of Claims 1 or 2.

## Patentansprüche

1. Vorrichtung (100) für Satelliten, die ausgelegt ist, um eine Mehrzahl P von Eingangssendekanälen zu verstärken und flexibel auf N Ausgänge, die jeweils einem Strahlenbündel entsprechen, zu verteilen, wobei die Vorrichtung enthält:
- einen Kommutator (102), der wenigstens P Eingänge für die Lenkung der Mehrzahl P von Sendekanälen zu einer Mehrzahl von Ausgängen enthält,
- wenigstens eine Matrix (103) des Butler-Typs, wovon jeder Eingang mit einem Ausgang des Kommutators verbunden ist,
- wenigstens eine Matrix (104) des inversen Butler-Typs, wobei jeder Ausgang der Matrix des Butler-Typs über einen Verstärker (105) mit einem entsprechenden Eingang der Matrix des inversen Butler-Typs verbunden ist,
wobei die Vorrichtung (100) **dadurch gekennzeichnet ist, dass** sie eine Mehrzahl von Ausgangs-Demultiplexern (109) enthält, um eine Mehrzahl von Sendekanälen entsprechend der Frequenz zu trennen, wobei der Eingang jedes der Ausgangs-Demultiplexer mit einem Ausgang der Matrix des inversen Butler-Typs verbunden ist.

2. Vorrichtung nach Anspruch 1, **dadurch gekennzeichnet, dass** sie enthält:
- einen Kommutator (102) mit P Eingängen und Q Ausgängen für die Lenkung der P Sendekanäle zu den Q Ausgängen,
- k1 Matrizen des Butler-Typs (103), wovon jede Q/k1 Eingänge und Q/k1 Ausgänge besitzt, wobei k1 eine von Null verschiedene natürliche Zahl ist und Q ein ganzzahliges Vielfaches von k1 ist,
- k1 Matrizen des inversen Butler-Typs (104), wovon jede Q/k1 Eingänge und Q/k1 Ausgänge besitzt, wobei jeder Ausgang jeder der k1 Matrizen des Butler-Typs über einen Verstärker mit einem entsprechenden Eingang einer der k1 Matrizen des inversen Butler-Typs verbunden ist,
- Q Ausgangs-Demultiplexer (109), wovon jeder einen Eingang und k2 Ausgänge enthält, wobei jeder der Q/k1 Ausgänge, die jeder der Matrizen des inversen Butler-Typs zugeordnet sind, mit einem Eingang eines der Q Demultiplexer verbunden ist, wobei k2 eine von Null verschiedene natürliche Zahl ist, derart, dass N gleich Q·k2 ist.

3. Verstärkungssystem (200) für Satelliten, das ausgelegt ist, um eine Anzahl P von Eingangssendekanälen flexibel zu verteilen, wobei das System eine Anzahl P' von Eingängen aufweist, um P' Eingangssendekanäle zu empfangen, wobei die Anzahl P' von Eingängen größer als die Anzahl P von flexibel zu verteilenden Eingangssendekanälen ist, wobei das System **dadurch gekennzeichnet ist, dass** es enthält:
- eine Vorrichtung (202) nach einem der Ansprüche 1 oder 2, die ausgelegt ist, um P Eingangssendekanäle zu verstärken und flexibel zu verteilen,
- mehrere Verstärker (203) zum Verstärken der P' - P verbleibenden Sendekanäle.

4. Verstärkungssystem (200) nach Anspruch 3, **dadurch gekennzeichnet, dass** es mehrere Ausgangs-Multiplexer (204) enthält, wobei jeder der Ausgangs-Multiplexer einen Eingang besitzt, der mit einem Ausgang eines der Verstärker für die Verstärkung der P' - P verbleibenden Sendekanäle verbunden ist und ein weiterer Eingang mit der Vorrichtung nach einem der Ansprüche 1 oder 2 verbunden ist.
